# EUROPEAN PATENT SPECIFICATION

(11) **EP 0 374 690 B1**
(45) Date of publication and mention of the grant of the patent: **21.04.1993**
(21) Application number: 89122898.3
(22) Date of filing: 12.12.1989
(51) Int. Cl.: H01L 21/90

(54) **Programmable fusible link structure allowing for plasma metal etching.**
Programmierbare schmelzbare Verbindungsstruktur, die Plasmametallätzen erlaubt.
Structure de connexion fusible programmable permettant la gravure plasma de métaux.

(30) Priority: 19.12.1988 US 286458
(43) Date of publication of application: 27.06.1990
(73) Proprietor: NATIONAL SEMICONDUCTOR CORPORATION, Santa Clara California 95051-8090 (US)
(72) Inventor: Marazita, Frank, San Jose, CA 95112 (US); Readdie, John Easton, San Jose, CA 95129 (US); McFarlane, Brian, Campbell, CA 95008 (US)
(74) Representative: Sparing Röhl Henseler Patentanwälte

(56) References cited:
- EP-A- 0 162 145
- US-A- 4 740 485
- SOLID STATE TECHNOLOGY, November 1987, no. 11, Port Washington, New York, US, pages 83-87; H. ITOH et al.: "Tungsten CVD: Application to Submicron VLSICs"

## Description

This invention pertains to integrated circuit devices and more specifically to methods for forming fusible links in an integrated circuit device, and the resulting fusible link structures.

Integrated circuits utilizing fusible links are well known in the prior art; the method and structure respectively defined by the preamble of patent claims 1 and 16 are disclosed by EP-A-0 162 145. Such fusible links are useful, for example, for programming in the field, i.e., after the device has been manufactured and assembled by the manufacturer and shipped to the customer. For example, programmable read only memories (PROMs) and field programmable logic arrays (FPLAs) utilize fusible links to allow the customer to program a device electrically, rather than requiring an expensive and time consuming set of masks to be manufactured in order to program devices during fabrication by the integrated circuit manufacturer.

A number of techniques have been used to fabricate fusible links. For example, polycrystalline silicon, tungsten (W), titanium tungsten (TiW), and nichrome have all been used as fusible link material in integrated circuits.

Recent fusible link structures have concentrated on the use of a single layer of TiW serving as both a fuse link and metalization barrier to eliminate undesirable alloying of aluminum metalization and silicon. In practice, a layer of metalization, such as aluminum, is formed over a layer of fusible material and, using suitable masking techniques, the layer of metalization is patterned to form a desired electrical interconnect pattern. Thereafter, using another mask, exposed portions of the layer of fusible material are etched to form discrete fusible links. Both tungsten and titanium tungsten may be etched using suitable wet etching techniques, in order to pattern the layer of fusible material into discrete fusible links while providing good etching selectivity; i.e., by etching the tungsten or titanium tungsten with good speed, and not appreciably etching the metalization. Similarly, metalization layers such as aluminum may be wet etched using, for example, phosphoric acid, in order to pattern the metalization layer into a desired electrical interconnect pattern, while not appreciably etching the fusible material. Due to the good etching selectivity available with respect to metalization versus fusible material, separate steps of wet etching of metalization and fuse material in order to form an electrical interconnect pattern and discrete fusible links have been utilized.

As integrated circuits become more dense, plasma etching has found application as a substitute for wet etching since plasma etching allows smaller geometries with significantly less undercutting and lateral etching. However, the plasma environments suitable for etching aluminum, such as Cl, CCl₄, or a combination thereof, do not provide good selectivity with respect to the etching of tungsten and titanium tungsten. Thus plasma etching has not been available in a straight-forward manner for forming fusible link structures, and wet etching techniques remain the norm for patterning the first layer of metalization as well as the layer of fusible material. One prior art technique employes a first plasma etch step for etching an aluminum layer for a time insufficient to etch the underlying fusible material, and a subsequent wet etch step for patterning the underlying fusible material. While this prior art technique theoretically provides desired selectivity between etching of aluminum metallization and the underlying fusible material, it is a two step process, and is very difficult to maintain since any excessive plasma etching will cause undesired etching not only of the aluminum, but of the underlying fuse material.

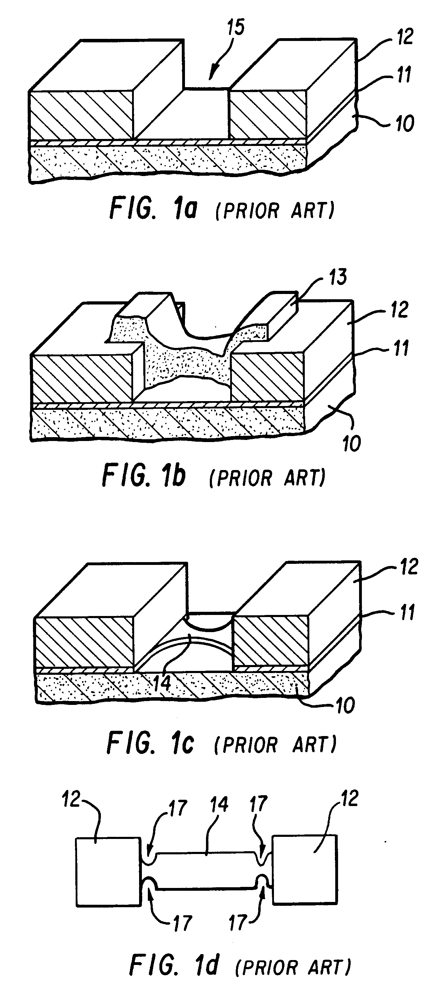

A typical prior art fuse device and its method of manufacture is depicted in Figures 1a through 1c. As shown in Figure 1a, a semiconductor substrate 10 include active areas such as transistors. On the top surface of substrate 10 is formed a layer 11 of titanium tungsten to a thickness of approximately 7.10⁻⁸m (700Å). Aluminum metallization layer 12 is then formed on titanium tungsten layer 11 and patterned into the desired metallization interconnect pattern, for example using phosphoric acid which etches aluminum layer 12 but which does not appreciably attack the underlying titanium tungsten layer 11. As shown in Figure 1a, each end of a to-be-formed fuse 14 (Fig 1c) is electrically contacted by separate portions of metallization layer 12, with gap 15 formed therebetween.

Referring to Figure 1b, a masking layer 13, such as photoresist, is formed in order to define those portions of titanium tungsten layer 11 which are to remain in regions not covered by the remaining portions of aluminum metallization layer 12, and thus will serve as discrete fuses.

Referring to Figure 1c, the exposed portions of titanium tungsten layer 11 are then removed by wet etching, for example with H₂O₂, which does not appreciably attack the remaining portions of aluminum metalization layer 12. The masking material 13 is then removed, and bow-tie shaped fuse 14 is shown electrically connected on each of its ends with a portion of patterned metallization interconnect layer 12.

Of importance, the prior art structure of Figures 1a through 1c including metallization interconnect layer 12 and fuse 14 must be fabricated using wet etching, since plasma atmospheres which could be utilized to etch aluminum layer 12 into a desired pattern would also undesirably etch titanium tungsten layer 11, and vice versa. It is, of course, possible to cover portions of aluminum layer 12 which are to remain intact with photoresist layer 13 for protection during etching of fusible layer 11, although this would require very precise alignment or the ultimate dimensions of the finished fuse to be greater in order to allow for misalignment between masking layer 13 and aluminum metallization layer 12.

However, it is not possible to reliably prevent plasma etching of portions of aluminum metalization layer 12 without appreciable damage to the underlying portions of titanium tungsten layer 11, once the overlying aluminum is removed. Another problem with the prior art technique shown in Figures 1a through 1c is that titanium tungsten layer 11 serves not only as the fuse material, but as the barrier material serving to prevent alloying, which causes electrical shorts, between aluminum metallization layer 12 and diffused regions within substrate 10 to which it is connected. This means that the thickness of titanium tungsten layer 11 must be sufficient to prevent alloying, and cannot be reduced to a value less than this thickness, as would be desired to reduce the current and voltage required to cause fuse 14 to open during programming.

Yet another disadvantage of this prior art technique is the reflections from the sidewalls of aluminum layer 12 during patterning of photoresist layer 13, which requires the use of the bow-tie shape for the fuse, rather than the use bar (rectangular) fuses. As is well known in the art, such reflections from the sidewalls of aluminum layer 12 result, as shown in Figure 1d, in undesirable notches 17 in fuse 14 due to overexposure of portions of the photoresist layer due to such reflections. Such notching occurs very close to those portions of metalization layer 12 which serve as electrical connections to fuse 14. During programming, it is desired to cause the fuse to open near the middle of the fuse, rather than the ends. Unfortunately, the notching problem shown in Fig. 1d will cause the fuse to open near metalization layer 12 during programming, resulting in reliability problems.

In accordance with the teachings of this invention, a novel fuse structure and method of manufacture is taught which allows the use of plasma etching of metalization materials without inadvertently etching fuse materials, and vice versa. In accordance with one embodiment of this invention, a layer of fuse material such as tungsten which will be patterned into fuse elements is formed on the surface of a substrate. In the fuse area, a masking layer is formed and patterned to define the to-be-formed fuse elements, and subsequently a barrier metal such as titanium tungsten is formed over the entire surface of the device in order to act as a barrier metal between subsequently formed aluminum metallization and the substrate. A layer of metallization is then formed on the entire surface of the device. A metal mask is then formed on the device and undesired portions of the metallization layer are removed to leave a desired metallization interconnect pattern. Simultaneously, portions of the layer of fuse material are removed in areas which are not protected by the remaining portions of the metalization layer or by the masking layer covering the desired fuses. The use of the masking layer serves as an etchant barrier during plasma etching of the metallization, thereby masking the fuse element from the plasma etchant.

In another embodiment of this invention, the aforementioned layer of tungsten is replaced with a layer of titanium tungsten which serves both as the fuse elements and a barrier metal. In accordance with this embodiment, a subsequent layer of titanium tungsten is not needed.
Figures 1a through 1c depict a typical prior-art fuse element and its method of manufacture;
Figure 1d depicts the problem with notching due to reflections from sidewalls of a metallization layer;
Figures 2a through 2e depict one embodiment of a fuse element constructed in accordance with teachings of this invention and one embodiment of a method for manufacturing such a fuse element; and
Figure 3 is a diagram depicting an alternative embodiment of a fuse element constructed according to the teachings of this invention.

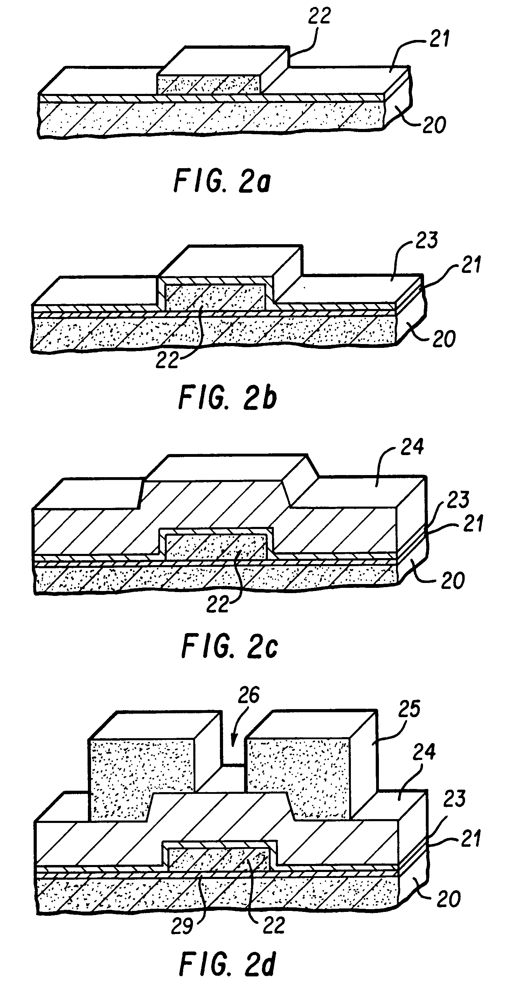

Figures 2a through 2e depict one embodiment of a fusible link structure constructed in accordance with the teachings of this invention, together with one embodiment of a method for fabricating such a structure. As shown in Figure 2a, substrate 20 includes one or more active areas, including elements such as transistors and the like. Formed on substrate 20 is a layer 21 of fusible material such as tungsten, titanium tungsten, or nichrome. Although not depicted in Figures 2a through 2e, substrate 20 consists of a semiconductor layer having a dielectric layer formed thereon such that layer 21 of fusible material is insulated from the underlying semiconductor material by the dielectric layer. Layer 21 is typically formed to a thickness within the range of approximately 2.10⁻⁸m (200Å) to 8.10⁻⁸m (800Å), for example by a well known sputtering technique. Naturally, it is to be understood that the teachings of this invention apply equally well regardless of the type of fusible material used, its thickness, or its method of formation.

Still referring to Figure 2a, a layer 22 of masking material, for example, oxide, nitride, or a combination thereof, is formed on layer 21 in areas where fuses are to be formed. In one embodiment of this invention, masking layer 22 is formed by chemical vapor deposition (CVD) of oxide to a thickness within the range of approximately 10⁻⁷m (1000Å) to 2.10⁻⁷m (2000Å). Using suitable well known photolithographic and etching techniques, masking layer 22 is patterned as shown in Figure 2a to protect that portion of layer 21 which is to remain as a fuse.

Referring now to Figure 2b, barrier layer 23 is formed on the surface of the device. Barrier layer 23 is formed, for example, of titanium tungsten sputtered to a thickness within a range of approximately 10⁻⁷m (1000Å) to 2.10⁻⁷m (2000Å). Naturally, any other suitable barrier materials, thicknesses, and methods of formation may be used, or the layer of barrier material may be omitted, if desired.

Referring to Figure 2c, metallization layer 24 is then formed on the surface of the device. Metallization. layer 24 is typically formed of aluminum or an alloy thereof, or a multiple layer construction including a final layer which serves as an anti-reflective coating. Metallization layer 24 is typically formed to a thickness within the range of approximately 5.10⁻⁷m to 1,5.10⁻⁶m (5000Å to 15000Å), for example by well known sputtering techniques.

Referring to Figure 2d, a layer of masking material 25, such as photoresist, is then formed on metallization layer 24 in order to expose those portions of metallization layer 24 which are to be removed in order to cause metallization layer 24 to have a desired pattern for providing electrical interconnection between various active areas within substrate 20, to-be-formed fuses, and higher levels of electrical interconnects (not shown). As shown in Figure 2d, patterning masking material 25 leaves opening 26 above to-be-formed fuse device 29, as well as exposing other areas of metallization layer 24 which are to be removed.

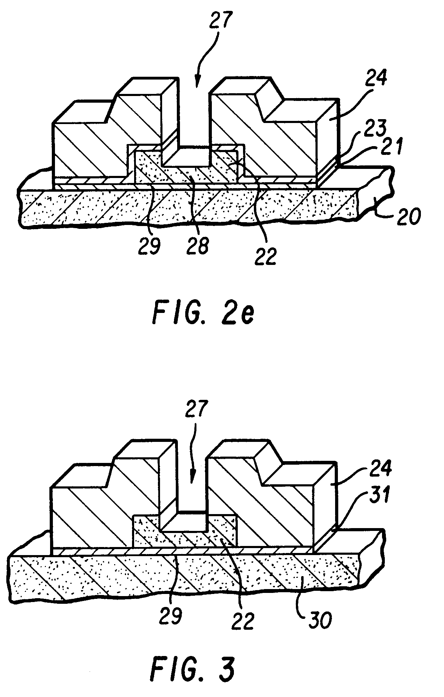

Referring to Figure 2e, unmasked portions of metallization layer 24 are then removed, for example by plasma etching in an atmosphere of Cl₂, CCl₄, or a combination thereof. In addition to removing unmasked portions of metallization layer 24, this etching forms trench 27 which etches through that portion of barrier layer 23 lying above fuse device 29, and possibly, depending on the etching characteristics of a fuse masking portion 28 of layer 22, continuing slightly into, but not through, masking portion 28. Masking layer 22 is not etched appreciably during this time due to its relatively high etching selectivity with respect to the material forming metallization layer 24, barrier layer 23, and fusable material of layer 21. This etch also removes undesired portions of barrier layer 23 and fusible material layer 21 outside of the fuse area, when they become exposed by the removal of overlying metalization. In this manner, an etch which is not selective with respect to the metallization material of metallization layer 24, the barrier material of barrier layer 23, and the fuse material of fuse layer 21 is utilized to simultaneously remove undesired portions of each of these three layers, while the desired portions of metallization layer 24 is protected by masking layer 25 and desired portions of fuse layer 21, for example fuse device 29, are protected by masking layer 28.

In accordance with the teachings of this invention, the embodiment of Figure 2e allows the thickness of fuse layer 21 to be made as thin as practical, for example within the range of 2.10⁻⁸m to 5.10⁻⁸m (200Å to 500Å), without the possibility of undesired alloying between metallization layer 24 and substrate 20, since a separate barrier layer 23 is utilized of any convenient thickness. By allowing fuse material layer 21 to be made as thin as possible, low fusing voltage and current are required during programming.

In an alternative embodiment of this invention as shown in Figure 3, a single layer 31 is used either as a layer of fusing material such as tungsten, or a layer which serves as both fusing material and barrier metal, such as titanium tungsten. In this embodiment, a separate layer such as layer 23 of Figure 2e is not needed.

In accordance with the teachings of this invention, either the structure of Figure 2e or the structure of Figure 3 may be made utilizing bar fuses having a rectangular plan view, rather than the bow-tie shaped fuse of Figure 1c. In accordance with the teachings of this invention, the fuse pattern is defined within masking layer 22 prior to patterning of metallization layer 24, and thus the photoresist layer used to define the fuse layer is not affected by reflections or distortions from a metallization layer. Thus, the teachings of this invention allow more compact fuses having higher reliability than possible in the prior art.

## Claims

1. A method for forming a fuse in an integrated circuit comprising the steps of:
forming a layer of fusible material (21) above a surface of a substrate (20);
forming a patterned layer of masking material (22) over said layer of fusible material;
forming a layer of metallization (24) on the surface of said integrated circuit; and exposing those portions of said metallization layer which are to be removed to an etchant, thereby removing said undesired portions of said metallization layer to leave a desired metallization interconnect pattern, said etchant not etching through said layer of masking material;
characterized in that
said layer of masking material (22) is formed over said layer of fusible material (21) in a pattern defining the portion of said layer (21) which is to remain intact in order to serve as a fuse.

2. A method as in claim 1 which further comprises the step of forming a layer of barrier material (23) on the surface of said layer of fusible material and said patterned layer of masking material.

3. A method as in claims 1 or 2 wherein said layer of fusible material comprises tungsten or titanium tungsten.

4. A method as in claims 1 or 2 wherein said layer of masking material comprises an oxide, a nitride, or a combination of an oxide and a nitride.

5. A method as in claims 1 or 2 wherein said layer of metallization comprises aluminium, an alloy of aluminium, or a multiple layer structure including an antireflective coating.

6. A method as in claim 1 wherein said etchant is capable of etching said metallization and said fusible material without significant selectivity.

7. A method as in claim 2 wherein said etchant is capable of etching said metallization, said fusible material, and said barrier material without significant selectivity.

8. A method as in claims 6 or 7 wherewin said etchant is a plasma.

9. A method as in claim 8 wherein said plasma comprises Cl₂, CCl₄, or a combination thereof.

10. A method as in claim 1 wherein said layer of fusible material comprises tungsten formed to a thickness within the range of approximately 200 Å to 500 Å.

11. A method as in claim 1 wherein said layer of fusible material comprises titanium tungsten formed to a thickness within the range of approximately 200 Å to 500 Å.

12. A method as in claim 7 wherein said layer of fusible material comprises tungsten and said layer of barrier material comprises titanium tungsten.

13. A method as in claim 12 wherein said layer of tungsten is formed to a thickness in the range of approximately 200 Å to 500 Å.

14. A method as in claim 12 wherein said layer of titanium tungsten is formed to a thickness within the range of approximately 1000 Å to 2000 Å.

15. A method as in claims 1 or 2 wherein said fuse is substantially rectangular in plan view.

16. An integrated circuit structure comprising:
a semiconductor substrate (20) having a top surface;
a layer of fusible material (21) formed above said top surface of said substrate;
a layer of masking material (22) formed above said layer of fusible material;
a layer of metallization (24) formed above said top surface of said substrate, said layer of fusible material, and said layer of masking material; said layer of metallization being patterned into a desired electrical interconnect pattern;
characterized in that
said layer of masking material (22) is formed in a pattern defining the location of one or more fuses.

17. A structure as in claim 16 wherein said layer of fusible material comprises tungsten or titanium tungsten.

18. A structure as in claim 6 wherein said layer of masking material comprises an oxide, a nitride, or a combination of an oxide an a nitride.

19. A structure as in one of claims 16 or 18 wherein said layer of metallization comprises aluminium, an alloy of aluminium, or a multiple layer structure including an antireflective coating.

20. A structure as in one of claims 16 to 19 wherein said layer of fusible material comprises tungsten or titanium tungsten formed to a thickness within the range of approximately 200 Å to 500 Å.

21. A structure as in claim 16, 18, or 19, which further comprises a layer of barrier material formed between said layer of metallization and said layers of fusible material and patterned layer of masking material.

22. A structure as in claim 21 wherein said layer of fusible material comprises tungsten and said layer of barrier material comprises titanium tungsten.

23. A structure as in claim 22 wherein said layer of tungsten is formed to a thickness in the range of approximately 200 Å to 500 Å.

24. A structure as in claims 22 or 23 wherein said layer of titanium tungsten is formed to a thickness within the range of approximately 1000 Å to 2000 Å.

## Patentansprüche

1. Ein Verfahren zum Bilden einer Schmelzsicherung in einem integrierten Schaltkreis, umfassen die Schritte:
Bilden einer Schicht aus schmelzbarem Material (21) über einer Oberfläche eines Substrats (20);
Bilden einer bemusterten Maskiermaterialschicht (22) über der Schicht aus schmelzbarem Material;
Bilden einer Metallisierungsschicht (24) auf der Oberfläche des integrierten Schaltkreises und Ätzen jener Abschnitte der Metallisierungsschicht, die abzutragen sind, wodurch die unerwünschten Abschnitte der Metallisierungsschicht abgetragen werden unter Belassung eines definierten Metallisierungsverdrahtungsmusters, wobei das Ätzmittel nicht durch die Maskiermaterialschicht ätzt, dadurch gekennzeichnet, daß
die Maskiermaterialschicht (22) über der Schicht aus schmelzbarem Material (21) in einem Muster gebildet wird, die den Abschnitt der genannten Schicht (21) definiert, welcher intakt bleiben muß, um als Schmelzsicherung zu dienen.

2. Ein Verfahren nach Anspruch 1, das den weiteren Schritt umfaßt der Bildung einer Schicht aus Barrierematerial (23) auf der Oberfläche der Schicht aus schmelzbarem Material und der bemusterten Maskiermaterialschicht.

3. Ein Verfahren nach Anspruch 1 oder 2, bei dem die Schicht aus schmelzbaren Material Wolfram oder Titanwolfram umfaßt.

4. Ein Verfahren nach Anspruch 1 oder 2, bei dem die Maskiermaterialschicht ein Oxid, ein Nitrid oder eine Kombination aus einem Oxid und einem Nitrid umfaßt.

5. Ein Verfahren nach Anspruch 1 oder 2, bei dem die Metallisierungsschicht Aluminium, eine Aluminiumlegierung oder eine Mehrschichtenstruktur einschließlich einer anti-reflektiven Beschichtung umfaßt. umfaßt.

6. Ein Verfahren nach Anspruch 1, bei dem das Ätzmittel in der Lage ist, die Metallisierung und das schmelzbare Material ohne merkliche Selektivität zu ätzen.

7. Ein Verfahren nach Anspruch 2, bei dem das Ätzmittel in der Lage ist, die Metallisation, das schmelzbare Material und das Barrierematerial ohne merkbare Selektivität zu ätzen.

8. Ein Verfahren nach Anspruch 6 oder 7, bei dem das Ätzmittel ein Plasma ist.

9. Ein Verfahren nach Anspruch 8, bei dem das Plasma Cl₂, CCl₄ oder eine Kombination derselben umfaßt.

10. Ein Verfahren nach Anspruch 1, bei dem die Schicht aus schmelzbarem Material Wolfram umfaßt, gebildet mit einer Dicke innerhalb des Bereichs von etwa 200 Å bis 500 Å.

11. Ein Verfahren nach Anspruch 1, bei dem die Schicht aus schmelzbarem Material Titanwolfram umfaßt, gebildet mit einer Dicke im Bereich von etwa 200 Å bis 500 Å.

12. Ein Verfahren nach Anspruch 7, bei dem die Schicht aus schmelzbarem Material Wolfram und die Schicht aus Barrierematerial Titanwolfram umfaßt.

13. Ein Verfahren nach Anspruch 12, bei dem die Wolframschicht mit einer Dicke im Bereich von etwa 200 Å bis 500 Å gebildet wird.

14. Ein Verfahren nach Anspruch 12, bei dem die Titanwolframschicht mit einer Dicke im Bereich von etwa 1000 Å bis 2000 Å gebildet wird.

15. Ein Verfahren nach Anspruch 1 oder 2, bei dem die Schmelzsicherung in Draufsicht im wesentlichen rechteckig ist.

16. Eine integrierte Schaltkreisstruktur, umfassend:
ein Halbleiterstruktur (20) mit einer oberen Oberfläche,
eine Schicht aus schmelzbarem Material (21), gebildet über der oberen Oberfläche des Substrats,
eine Schicht aus Maskiermaterial, gebildet über der Schicht aus schmelzbarem Material,
eine Metallisationsschicht (24), gebildet über der oberen Oberfläche des Substrats der Schicht aus schmelzbarem Material und der Schicht aus Maskiermaterial, wobei die Metallisationsschicht bemustert ist in ein gewünschtes elektrisches Verdrahtungsmuster,
dadurch gekennzeichnet, daß die Schicht aus Maskiermaterial (22) in einem Muster gebildet wird, das die Stelle einer oder mehrerer Schmelzsicherungen definiert.

17. Eine Struktur nach Anspruch 16, bei der die Schicht aus schmelzbarem Material Wolfram oder Titanwolfram umfaßt.

18. Eine Struktur nach Anspruch 16, bei der die Schicht aus Maskiermaterial ein Oxid, ein Nitrid oder eine Kombination eines Oxids und eines Nitrids umfaßt.

19. Eine Struktur nach einem der Ansprüche 16 oder 18, bei der die Metallisationsschicht Aluminium umfaßt, eine Aluminiumlegierung oder eine Mehrlagenstruktur einschließlich einer anti-reflektiven Beschichtung.

20. Eine Struktur nach einem der Ansprüche 16 bis 19, bei der die Schicht aus schmelzbarem Material Wolfram oder Titanwolfram umfaßt, gebildet mit einer Dicke innerhalb des Bereichs von etwa 200 Å bis 500 Å.

21. Eine Struktur nach Anspruch 16, 18 oder 19, die ferner eine Schicht aus Barrierematerial umfaßt, gebildet zwischen der Metallisationsschicht und den Schichten aus schmelzbarem Material und der bemusterten Schicht aus Maskiermaterial.

22. Eine Struktur nach Anspruch 21, bei der die Schicht aus schmelzbarem Material Wolfram umfaßt und die Schicht aus Barrierematerial Titanwolfram umfaßt.

23. Eine Struktur nach Anspruch 22, bei der die Wolframschicht in einer Dicke im Bereich von etwa 200 Å bis 500 Å gebildet ist.

24. Eine Struktur nach Anspruch 22 oder 23, bei der die Schicht aus Titanwolfram mit einer Dicke innerhalb des Bereichs von etwa 1000 Å bis 2000 Å gebildet ist.

## Revendications

1. Un procédé pour former un fusible dans un circuit intégré, comprenant les étapes qui consistent à :
former une couche en un matériau fusible (21) pardessus une surface d'un substrat (20);
former une couche configurée d'un matériau de masquage (22) sur ladite couche en un matériau fusible;
former une couche de métallisation (24) sur la surface dudit circuit intégré;
et exposer les parties de ladite couche de métallisation qui doivent être enlevées, à un agent d'attaque chimique pour enlever les parties non-désirées de ladite couche de métallisation et laisser subsister une configuration souhaitée de métallisation d'interconnexions, ledit agent d'attaque n'attaquant pas à travers ladite couche en un matériau de masquage;
caractérisé en ce que ladite couche en un matériau de masquage (22) est formée par-dessus ladite couche en un matériau fusible (21) sous la forme d'une configuration définissant la partie de ladite couche (21) qui doit rester intacte afin de pouvoir servir comme fusible.

2. Un procédé selon la revendication 1, qui comprend également l'étape qui consiste à former une couche en un matériau de barrière (23) sur la surface de ladite couche en un matériau fusible et de ladite couche configurée en un matériau de masquage.

3. Un procédé selon l'une des revendications 1 ou 2, dans lequel ladite couche en un matériau fusible comprend le tungstène ou le tungstène-titane.

4. Un procédé selon l'une des revendications 1 ou 2, dans lequel ladite couche en un matériau de masquage comprend un oxyde, un nitrure ou une combinaison d'un oxyde et d'un nitrure.

5. Un procédé selon l'une des revendications 1 ou 2, dans lequel ladite couche de métallisation comprend de l'aluminium, un alliage d'aluminium ou une structure à couches multiples, comprenant un revêtement anti-réfléchissant.

6. Un procédé selon la revendication 1, dans lequel ledit agent d'attaque est capable d'attaquer ladite métallisation et ledit matériau fusible sans sélectivité significative.

7. Un procédé selon la revendication 2, dans lequel ledit agent d'attaque est capable d'attaquer ladite métallisation, ledit matériau fusible et ledit matériau de barrière sans sélectivité significative.

8. Un procédé selon l'une des revendications 6 ou 7, dans lequel ledit agent d'attaque est un plasma.

9. Un procédé selon la revendication 8, dans lequel ledit plasma comprend du Cl₂, CCl₄, ou une combinaison de ces deux substances.

10. Un procédé selon la revendication 1, dans lequel ladite couche en un matériau fusible comprend du tungstène formé jusqu'à une épaisseur allant d'environ 200Å à 500Å.

11. Un procédé selon la revendication 1, dans lequel ladite couche en un matériau fusible comprend du tungstène-titane formé jusqu'à une épaisseur allant d'environ 200Å à 500Å .

12. Un procédé selon la revendication 7, dans lequel ladite couche en un matériau fusible comprend du tungstène et ladite couche de matériau de barrière comprend du tungstène-titane.

13. Un procédé selon la revendication 12, dans lequel ladite couche de tungstène est formée jusqu'à une épaisseur allant d'environ 200Å à 500Å .

14. Un procédé selon la revendication 12, dans lequel ladite couche de tungstène-titane est formée jusqu'à une épaisseur allant d'environ 1000Å à 2000Å .

15. Un procédé selon l'une des revendications 1 ou 2, dans lequel ledit fusible est à peu près rectangulaire, vu en plan.

16. Une structure de circuit intégré comprenant :
un substrat semi-conducteur (20) présentant une surface supérieure;
une couche en un matériau fusible (21) formée sur ladite surface supérieure dudit substrat;
une couche en un matériau de masquage (22) formée par-dessus ladite couche en un matériau fusible;
une couche de métallisation (24) formée par-dessus ladite surface supérieure dudit substrat, ladite couche en un matériau fusible et ladite couche en un matériau de masquage, ladite couche de métallisation étant configurée en une configuration d'interconnexions électriques souhaitée,
caractérisée en ce que
ladite couche en un matériau de masquage (22) est formée dans une configuration qui définit l'emplacement de l'un ou de plusieurs fusibles.

17. Une structure selon la revendication 16, dans laquelle ladite couche en un matériau fusible comprend du tungstène ou du tungstène-titane.

18. Une structure selon la revendication 16, dans laquelle ladite couche en un matériau de masquage comprend un oxyde, un nitrure, ou une combinaison d'un oxyde et d'un nitrure.

19. Une structure selon l'une des revendications 16 ou 18, dans laquelle ladite couche de métallisation comprend de l'aluminium, un alliage d'aluminium ou une structure à couches multiples comprenant un revêtement anti-réfléchissant.

20. Une structure selon l'une quelconque des revendications 16 à 19, dans laquelle ladite couche en un matériau fusible comprend du tungstène ou du tungstène-titane formé jusqu'à une épaisseur allant d'environ 200Å à 500Å .

21. Une structure selon l'une quelconque des revendications 16, 18 ou 19, comprenant en outre une couche en un matériau de barrière formée entre ladite couche de métallisation et lesdites couches en un matériau fusible et ladite couche configurée en un matériau de masquage.

22. Une structure selon la revendication 21, dans laquelle ladite couche en un matériau fusible comprend du tungstène et ladite couche en un matériau de barrière comprend du tungstène-titane.

23. Une structure selon la revendication 22, dans laquelle ladite couche de tungstène est formée jusqu'à une épaisseur allant d'environ 200Å à 500Å .

24. Une structure selon l'une des revendications 22 ou 23, dans laquelle ladite couche de tungstène-titane est formée jusqu'à une épaisseur allant d'environ 1000Å à 2000Å .
